# FASCICULE DE BREVET EUROPEEN

(11) **EP 3 631 864 B1**
(45) Date de publication et mention de la délivrance du brevet: **05.04.2023**
(21) Numéro de dépôt: 18810527.4
(22) Date de dépôt: 04.06.2018
(51) Int. Cl.: H01L 31/0352, H01L 31/0376, H01L 31/18, H01L 31/20, H01L 31/068, H01L 31/0747, H01L 21/265

(54) **PROCÉDÉ DE FABRICATION D'UN CONVERTISSEUR LUMIÈRE-ÉLECTRICITÉ TOUT EN SILICIUM POUR UNE PHOTOCONVERTION GÉANTE**
VERFAHREN ZUR HERSTELLUNG EINES VOLLSTÄNDIG AUS SILIZIUM HERGESTELLTEN LICHT-STROMWANDLERS FÜR EINE RIESIGE FOTOUMWANDLUNG
METHOD FOR THE PRODUCTION OF A LIGHT-TO-ELECTRICITY CONVERTER MADE ENTIRELY FROM SILICON FOR A GIANT PHOTOCONVERSION

(30) Priorité: 01.06.2017 FR 1700583
(43) Date de publication de la demande: 08.04.2020
(73) Titulaire: Segton Advanced Technologie SAS, 77800 Versailles (FR)
(72) Inventeur: KUZNICKI, Zbigniew, 67800 Hoenheim (FR)
(74) Mandataire: Staeger & Sperling Partnerschaftsgesellschaft mbB
(86) Numéro de dépôt international: PCT/FR2018/000155
(87) Numéro de publication internationale: WO 2018/220299

(56) Documents cités:
- FR-A1- 2 722 612
- FR-A1- 2 801 726
- FR-A1- 3 005 789
- JP-A- S57 132 373
- J. TRZMIEL ET AL: "Dielectric spectroscopy investigations of nanostructured silicon", CURRENT APPLIED PHYSICS, vol. 14, no. 8, 1 août 2014 (2014-08-01), pages 991-997, XP055532722, AMSTERDAM, NL ISSN: 1567-1739, DOI: 10.1016/j.cap.2014.05.004
- J.LE PERCHEC ET AL: "19.3% Efficiency on P-Type Silicon Solar Cells by Pulsion Plasma-Immersion Implantation", ENERGY PROCEDIA, vol. 33, 1 janvier 2013 (2013-01-01), pages 18-23, XP055533087, NL ISSN: 1876-6102, DOI: 10.1016/j.egypro.2013.05.035
- H. SCHLEMM ET AL: "Compact broad beam ion implantation of 25 keV N/sup +/ in silicon", ION IMPLANTATION TECHNOLOGY. PROCEEDINGS OF THE 11TH INTERNATIONAL CONFERENCE ON AUSTIN, TX, USA 16-21 JUNE 1996, NEW YORK, NY, USA,IEEE, US, 16 juin 1996 (1996-06-16), pages 400-403, XP010220694, ISBN: 978-0-7803-3289-8
- SZLUFCIK J ET AL: "Low-Cost Industrial Technologies of Crystalline Silicon Solar Cells", PROCEEDINGS OF THE IEEE, IEEE. NEW YORK, US, vol. 85, no. 5, 1 mai 1997 (1997-05-01), pages 711-730, XP011043842, ISSN: 0018-9219, DOI: 10.1109/5.588971
- ALI KHURAM ET AL: "Process optimization of doping conditions for (100) P-type monocrystalline silicon solar cell using response surface methodology", JOURNAL OF PHOTONICS FOR ENERGY, SOCIETY OF PHOTO-OPTICAL INSTRUMENTATION ENGINEERS, 1000 20TH ST. BELLINGHAM WA 98225-6705 USA, vol. 3, no. 1, 1 janvier 2013 (2013-01-01) , pages 32099-1-32099-9, XP060026517, DOI: 10.1117/1.JPE.3.032099
- YOUNG DAVID L ET AL: "Plasma immersion ion implantation for interdigitated back passivated contact (IBPC) solar cells", 2016 IEEE 43RD PHOTOVOLTAIC SPECIALISTS CONFERENCE (PVSC), IEEE, 5 juin 2016 (2016-06-05), pages 225-229, XP033007563, DOI: 10.1109/PVSC.2016.7749583

## Description

L'invention concerne un procédé de fabrication de convertisseurs lumière-électricité tout en silicium avec systèmes nanoscopiques, en arrangements spécifiques à l'intérieur du silicium monocristallin pour déclencher une photoconversion géante.

Ce procédé de production comprend la modulation nanoscopique du silicium, et permet d'éviter les conflits résultant des étapes successives de fabrication par superposition des différentes phases de transformation du silicium, en respectant des facteurs géométriques ajustés.

Plus particulièrement, le procédé de fabrication comprend une modification locale du réseau cristallin de silicium en un nouvel arrangement à l'échelle nanométrique pour former un système spécifique, de façon à améliorer le rendement de la conversion lumière-électricité à l'aide des convertisseurs tout silicium. Il s'agit de l'exploitation de l'énergie cinétique d'électrons chauds devenue possible grâce aux mécanismes de la photoconversion géante (ang. Giant PhotoConversion, GPC) ; principalement de la faible énergie de génération et multiplication des électrons secondaires

### 1. CHAMP DE L'INVENTION

La présente invention se rapporte et s'étend au champ de la conversion de l'énergie de la lumière en électricité, et en particulier à toutes les applications aux convertisseurs lumière-électricité, cellules photoélectriques et cellules solaires photovoltaïques avec un rendement élevé. Il s'agit en particulier d'un procédé de fabrication d'un nouveau matériau photovoltaïque et de dispositifs photovoltaïques l'utilisant de très haut rendement grâce à la photoconversion géante.

Le présent procédé de production utilise des équipements de l'industrie photovoltaïque avec deux postes supplémentaires dédiés aux opérations spécifiques pour mettre en oeuvre des procédés complémentaires de fabrication des cellules photovoltaïques en silicium monocristallin.

Le convertisseur résultant peut-être utilisé, pour former des photovoltaïques montées électriquement en série, ou en parallèle dans des circuits appropriés, ainsi que sous la forme de feuilles, de tapis ou de matelas.

La publication FR 3005789 A1 concerne un system d'unités nanostructurées groupées formant à l'intérieur du silicium un métamatériau, elle concerne aussi le procédé de fabrication pour les y disposer de façon optimale. Les unités nanostructurées sont groupées et conditionnées selon un arrangement optimal au sein du silicium.

La publication FR2801726 A1 a pour objet un procédé de fabrication d'un dispositif ou d'une cellule photovoltaïque à haut rendement, caractérisé en ce qu'il consiste à appliquer à une lamelle ou plaquette de silicium.

La publication FR 2722612 A1 concerne un procédé de fabrication d'un matériau ou dispositif photovoltaïque, un matériau ou dispositif ainsi obtenu et une photopile comprenant un tel matériau ou dispositif.

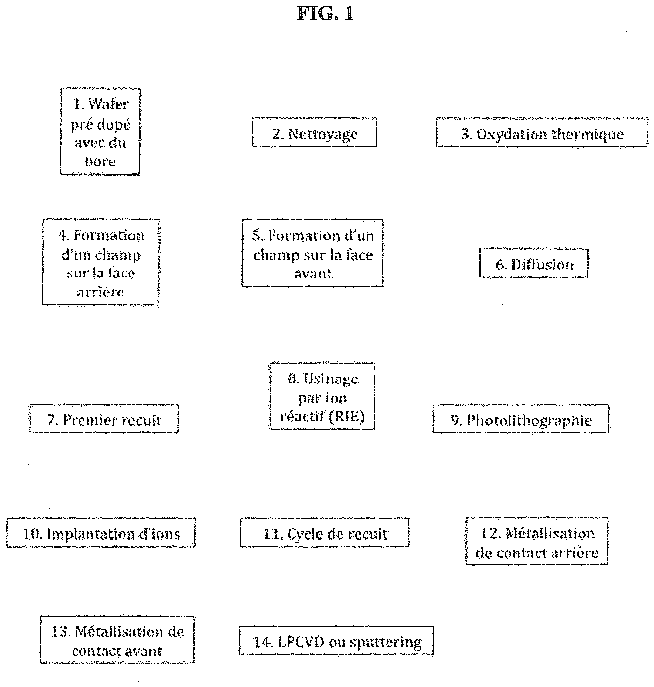

Une autre publication de l'état d'art est : J. TRZMIEL ET AL, "Dielectric spectroscopy investigations of nanostructured silicon", CURRENT APPLIED PHYSICS, AMSTERDAM, NL, (20140801), vol. 14, no. 8, doi:10.1016/j.cap.2014.05.004, ISSN 1567-1739, pages 991 - 997, XP055532722 [X] 1,19,20 * page 992, chapitre 2; figure 1, page 993, colonne de gauche, chapitre 2 * [Y] 2-18.

### 2. DEFINITIONS

Les définitions ci-dessous seront utilisées tout au long de la description qui suit.

**Métamatériau** : ce terme désigne un matériau artificiel, en particulier du silicium cristallin transformé, présentant des propriétés physiques qui vont au-delà des propriétés connues dites naturelles. Le métamatériau garde sa composition chimique originale. Plus spécifiquement, il prend la forme d'au moins une couche continue ou discontinue, mais aussi un champ de perles ou de grains ou de formes quelconques telles que des agglomérés ou des agrégats et qui permet une génération et multiplication de faible énergie d'électrons secondaires, un transport électronique spécifique, une sensibilité augmentée à l'intensité d'excitation lumineuse et une forte non linéarité optique.

**SEGTON** : [acronyme de *Secondary Electron Génération Tuned on Nanoscale*] est une unité élémentaire du réseau cristallin conditionnée, caractérisée par son original système des niveaux d'énergie d'électrons, lequel est très bien adapté à la conversion en plusieurs étapes de la lumière à l'électricité. SEGTON permet une génération et multiplication basse énergie d'électrons secondaires qui sont supplémentaires à la photogénération primaire des porteurs libres.

**SEG-MATTER** [acronyme de *Secondary Electron Génération* - *Matter*] est un métamatériau, c'est-à-dire le matériau cristallin spécifique créé dans un nanospace unique des interactions conjuguées : de structure, de dopage, de transport électronique et des champs physiques forts pour une conversion lumière-électricité efficace qui contient des unités élémentaires appelées SEGTONS distribuées de manière homogène qui forment un super-réseau ordonné immergé dans un environnement physique spécifique bordé de nanomembranes. Une nouvelle cristallinité apporte en nanoéchelle des fonctionnalités complémentaires souhaitées.

Plus généralement, cette expression désigne également le procédé de production pour fabriquer la matière capable d'exploiter un ensemble de niveaux d'énergie des SEGTONs.

**Nanomembrane** : c'est une hétérointerface ou une surface (verticale, horizontale, parallèle à la surface, plus ou moins sphérique ou non) sur laquelle se fait un changement du modèle de bande d'énergie d'électrons, de mode de conduction et ainsi de suite. Il s'agit par exemple, de l'interface entre deux phases cristallines de silicium : la SEG-MATTER et le silicium naturel non transformé environnant, qui se caractérise par la modification du mode de transport des électrons.

**MTM** : métamatériau basé sur du silicium
a-Si : silicium amorphisé
< a-Si > : phase amorphisée du silicium sous contrainte mécanique
c-Si : silicium cristallin
< c-Si > : phase cristalline du silicium sous contrainte mécanique

**Lacune** : défaut structurel ponctuel dans un réseau cristallin.

**Bilacune** : défaut structurel ponctuel dans un réseau cristallin formé par deux lacunes interconnectées, formant une unité structurelle spécifique.

**BSF** : champ électrique à la face arrière, c'est à dire une jonction de type LH résultant d'une modification graduelle ou abrupte de la densité d'impuretés dopantes.

**RIE** : décapage par ions réactifs.

**LPCVD** : dépôt chimique par vapeur à basse pression.

**Nanoagrégats amorphisés** : agrégats amorphisés ou nanogroupes de la matière cristalline localement transformée, préférentiellement de silicium, qui aura été incluse par n'importe quel procédé de production approprié dans le milieu cristallin.

**Nanostructures insérées** : nanoagrégats amorphisés, enveloppés par une nanocouche de SEG-MATTER, c'est-à-dire du métamatériau (MTM) capable de fournir de nombreux électrons secondaires résultant de collisions d'électrons chauds, distribuées de manière optimale à l'intérieur du convertisseur, de préférence l'émetteur.

**GPC** : *Giant PhotoConvertion* - Photoconversion Géante permettant l'exploitation optimale de l'énergie de tout le spectre solaire.

### 3. ARRIERE PLAN DE L'INVENTION

Actuellement, la fabrication de dispositifs photovoltaïques commerciaux est basée sur des transformations d'un semi-conducteur, par exemple le dopage par des impuretés, la formation de jonctions PN, la métallisation, la passivation électronique, les arrangements antireflets.

L'architecture classique, plutôt assez simple, d'une cellule photovoltaïque exploite des matériaux naturels qui ne peuvent être modifiés que dans une mesure limitée. La très large part des cellules est conçues sous forme d'un dispositif semi-conducteur à simple jonction collectrice planaire.

Cette vision des choses peut être enrichie par la création dédiée de sous-régions, de sous-systèmes, de sous-structures, qui complètent à l'échelle nanométrique la conception classique de l'architecture des dispositifs photovoltaïques.

Des années d'expérimentations multiples ont rendu possible la mise en oeuvre de méthodes de modulation du matériau semi-conducteur (principalement du silicium) à échelle nanométrique, pour atteindre des phénomènes nouveaux relatifs à la photoconversion géante.

L'état de l'art est largement illustré et documenté par la publication des demandes de brevets antérieures notamment déposés au nom de la société SEGTON AdT.

### 4. PROBLEME RESOLU PAR L'INVENTION

L'ajustement d'un convertisseur lumière-électricité à une plus grande partie du spectre solaire est compliqué, d'une part parce que, pour des raisons de mécanique quantique, la conversion n'est efficace et optimale que dans une sous-bande spectrale très étroite, et, d'autre part, parce que le spectre solaire total est trop étendu pour permettre des opérations performantes en utilisant des dispositifs à une seule jonction collectrice.

Deux façons de procéder sont possibles.
* conserver le même mécanisme unique d'interaction photons/électrons, exploité le plus efficacement dans des cellules en mode « TANDEM » (par exemple, avec divers matériaux de la famille GaAs), en créant un empilement de cellules ayant des bandes interdites complémentaires, permettant une photoconversion sur une étendue spectrale solaire plus importante que convertisseurs à une simple jonction, mais qui, en contrepartie, sont caractérisées par une collecte de courant bien plus difficile ainsi que par des problèmes de concentration de la lumière.
* introduire des mécanismes additionnels comme, par exemple, la génération et multiplication de faible énergie d'électrons secondares, avec ses nombreux mécanismes couplés comme la séparation fonctionnelle spécifique (les transformations locales du matériau, le transport électronique local et la collecte d'électrons photogénérés.

La présente invention concerne un procédé de fabrication de convertisseurs tout en silicium au rendement amélioré par la photoconversion géante grâce aux leurs sous-régions, sous-systèmes ou sous-structures, comme, par exemple, un système nanoscopique de couches enterrées, contenant un métamatériau photovoltaïque en silicium. Le procédé de fabrication conduit au dispositif intégrant la génération secondaire et la multiplication à faible énergie d'électrons secondaires avec la collecte optimale des photoporteurs ainsi créés.

La photoconversion géante représente une piste pour augmenter les rendements de la conversion de l'énergie lumineuse en électricité dans des dispositifs à une seule jonction collectrice. La multiplication des électrons à faible énergie est le premier mécanisme dans un semi-conducteur à « gap » indirect, qui a prouvé que le silicium pouvait être optimisé ainsi de manière spectaculaire à la conversion du spectre solaire en électricité.

La présente invention est d'une importance particulière parce que le silicium qui domine largement l'industrie photovoltaïque (surtout sous sa forme cristalline), ne présente pas de problèmes de ressource étant donné son abondance et sa facilité d'accès dans l'écorce terrestre. Son extraction ne pose pas de problème significatif de nature écologique, notamment celui de la toxicité, ainsi que de son recyclage. Les derniers développements, évoqués dans cette invention, des dispositifs en silicium qui constituent des dispositifs à photoconversion géante, représentent d'une certaine façon, un retour à la première génération photovoltaïque, et constituent des excellents perfectionnements de ses concepts fondateurs.

Une chaine de production de cellules photovoltaïques classiques en silicium peut être transformée rapidement et à un coût raisonnable en une ligne de production de cellules à photoconversion géante.

### 5. DESCRIPTION ABREGEE

Le présent processus innovant est de nature nano technologique. Il utilise les moyens, les équipements et les technologies mis en oeuvre pour le silicium. Il s'avère particulièrement important d'affirmer que tous ces moyens et opérations sont aujourd'hui complètement matures et au point.

Les étapes spécifiques du processus de fabrication comprennent une transformation partielle du silicium cristallin, en un arrangement nanoscopique optimal pour former un dispositif permettant d'améliorer le rendement de la conversion lumière-électricité. Tous les paramètres, processus, procédures et étapes de la fabrication des dispositifs de photoconversion géante ont été testés et validés séparément durant la fabrication d'une vingtaine de séries tests.

La première étape de la fabrication consiste à réaliser une cellule classique de silicium cristallin à jonction unique. Le phosphore, utilisé comme dopant, est diffusé durant cette étape dans le silicium déjà pré dopé de façon homogène, par exemple, avec du bore, de densité d'environ 5.10¹⁵ par centimètre cube.

La modulation nanoscopique est enterrée dans le silicium cristallin par une implantation amorphisante suivie d'un traitement thermique post implantation. Le faisceau incident d'ions amorphise localement le réseau cristallin de silicium dans une zone prédéterminée en épaisseur et en profondeur (des dizaines de nanomètres) avec une précision élevée grâce aux propriétés physiques du processus. L'amorphisation résultante n'a aucune utilité technique en tant que telle, et nécessite impérativement un traitement thermique complémentaire qui entraînera la recristallisation locale contrôlée sous forme d'une épitaxie en phase solide.

### 6. BENEFICES ET AVANTAGES DE L'INVENTION

La présente invention utilise pour la production de cellules photovoltaïques des machines industrielles exploitées individuellement dans le domaine de la microélectronique et de l'optoélectronique. Il faut quand même souligner que les méthodes microélectroniques ne sont pas directement compatibles en tant que telles avec les procédés de fabrication de la photoconversion géante à cause, d'au moins une raison, la surface active du dispositif.

Le but du procédé de production introduit ici est d'utiliser le plus largement possible des équipements existants, des méthodes validées, des sites de fabrication de produits photovoltaïques existants, mais aussi ceux initialement mis en place pour des fabrications de microélectronique, optoélectronique ou pour des micro et nanotechnologies.

Pratiquement tous les équipements, outils, machines, ensembles de machines, sont normalement disponibles sur le marché ainsi que des sites de production dédiés à l'électronique, le photovoltaïque et à la microélectronique. Toutes les étapes de la fabrication de cellules photovoltaïques GPC à photoconversion géante peuvent fonctionner sur des équipements existants avec des adaptations plutôt mineures. La fabrication à grande échelle peut être opérée avec des machines dédiées pour les conditions bien définies et restrictives de la production de masse des convertisseurs et convenablement adaptées et, par conséquent, notablement moins chères.

### 7. LES OBJECTIFS DE L'INVENTION

Cette invention a trait à un procédé de production de convertisseurs lumière-électricité tout en silicium incorporant des nanosystèmes conditionnés en arrangements spécifiques à l'intérieur d'une plaquette de silicium cristallin pour une application optoélectronique par exemple pour une GPC.

Le procédé de production développé et vérifié en pratique, mène à une complète modulation nanoscopique du matériau cristallin en évitant les conflits entre les différentes étapes successives de fabrication.

Comme cela a été montré précédemment, le problème le plus spécifique concerne la concaténation d'opérations, enchaînées consécutivement les unes après les autres, parce que certaines de ces opérations s'excluent l'une l'autre si l'ordre n'est pas correctement respecté.

Il y a plusieurs méthodes et opérations qui sont bien connues à titre individuel, dans le domaine de la microélectronique, mais ne peuvent pas être appliquées en tant que tel, dans un cycle complet de fabrication d'un dispositif de photoconversion géante. En général, la solution efficace requiert une séquence originale d'opérations connues, qui doivent être paramétrées selon les spécificités propres aux convertisseurs à génération secondaire.

### 8. BREVE DESCRIPTION DES DESSINS

Figure1 : représente un organigramme général de toutes les étapes importantes de fabrication d'un dispositif à photoconversion géante.

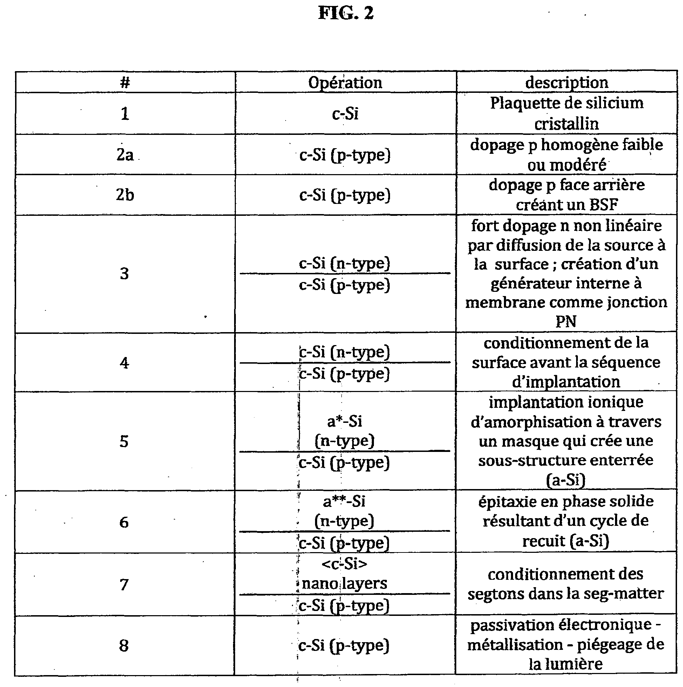

Figure2 : est un tableau présentant le procédé étape par étape.

### 9. DESCRIPTION COMPLETE DU PROCEDE DE FABRICATION

L'invention se rapporte à la méthode définie par l'objet de la revendication 1.

Ce qui suit est une courte mais complète liste descriptive, en tant qu'exemple concernant les principales spécifications de fabrication adaptées à un procédé industriel complet de fabrication.

De façon générale, le procédé de production en petites séries de dispositifs de photoconversion géante est basé sur un traitement multi étape de plaquettes de silicium. Le nombre de ces étapes dépend entre autres de l'état initial des plaquettes de silicium fournies en état plus ou moins pré conditionnées.

Des exemples de quelques étapes principales de procédés sont mentionnées ci-dessous :
Choix d'épaisseur de la plaquette de silicium : l'épaisseur doit être adaptée du point de vue mécanique à toutes les opérations technologiques.
Surface : les premières étapes de fabrication concernent la qualité de surface de la plaquette de silicium (RCA, purification microélectronique), polissage à froid de la surface de la plaquette de silicium pour le libérer d'oxyde natif.
Oxydation sacrificielle : oxydation dite profonde (à 100 nanomètres) suivie d'un décapage de l'oxydation initiale (95 nanomètres) avec conservation d'une nanocouche SiO₂ (environ 5 nanomètres d'épaisseur) comme passivation électronique de la surface.
   - ou un décapage total de l'oxydation initiale suivi du dépôt de 70 nm servant comme une nanocouche-source de la diffusion de P₂O₅ suivi à son tour d'un décapage jusqu'à 5 nm d'épaisseur
Passivation électronique durant la fabrication : conservation d'une nanocouche (environ 5 nanomètres d'épaisseur) de SiO₂ ou de P₂O₅ après l'oxydation et la diffusion pour protéger la surface de silicium durant l'implantation.
Diffusion de donneurs : diffusion de phosphore à partir de la nanocouche-source de P₂O₅ pour établir un profil P et créer une interface de la jonction PN.
Masques de protection : protections intermittentes des surfaces avant et arrière entre des opérations technologiques successives.
Implantation : implantation amorphisante d'ions à travers des nanocouches surfaciques de protection (environ 5 nanomètres d'épaisseur) avec l'exigence d'excellentes caractéristiques géométriques de planéité.
Masques d'implantation : pour des amorphisations discontinues correspondant à des motifs de sous-structures enterrées.
Traitement thermique : recuit adapté au régime de températures admissibles correspondant au dépôt de l'énergie thermique nécessaire pour moduler le matériau transformé à travers une épitaxie en phase solide.
Conditionnement des SEGTONs et de la SEG-MATTER : épitaxie ralentie en phase solide assurant la calibration des sous-systèmes actifs.
Sous-structures enterrées : sous-systèmes actifs insérés dans l'émetteur en fonction de l'architecture de convertisseur confirmée.
Passivations électroniques : couches de passivation et protection électronique déposées après les procédés de conditionnement des SEGTONs et de la SEG-MATTER.
Surface arrière : création d'un profil d'accepteur (B) par diffusion ou par implantation pour former un BSF (ang. Back Surface Field) ; passivation électronique ; miroir arrière ; grille de contact.
Miroir arrière : système des couches de SiO₂/Al sur la face arrière pour un piégeage optique.

### Recuit et conditionnement de contact.

Ensuite, sont décrit quelques exemples sélectionnés de l'ensemble du processus de fabrication selon des séquences correctement accommodés d'opérations connues déjà individuellement surtout dans la microélectronique, qui doivent être paramétrées d'après les spécificités d'un cycle de fabrication d'un dispositif de photoconversion géante.

### Exemples d'enchaînement des opérations d'un cycle de fabrication

### 9.1 Plaquette de silicium pré dopé préférentiellement avec du bore

^{∗} Plaquette de silicium monocristallin CZOCHRALSKI - CZ-Si ou à zone flottée FZ-Si.
^{∗} Dopage au phosphore (P) préférentiellement de l'ordre de 10¹⁸ par centimètre cube avec le pré-dopage au bore (B) en concentration usuelle de l'ordre de 10¹⁵ par centimètre cube.
^{∗} Face avant et arrière nettoyées mais non nécessairement polies.
^{∗} Orientation cristalline < 100 >.

### 9.2 Nettoyage

^{∗} Bain RCA dans une station de nettoyage chimique.
^{∗} Nettoyage par une oxydation sacrificielle thermique à une température de 850°C pendant approximativement 2 heures menant à une couche sacrificielle de SiO₂ ayant une épaisseur allant de 50 à 100 nanomètres.

### 9.3 Oxydation thermique

Dans un four à diffusion d'ions oxygène.

### 9.4 Formation d'un champ à la face arrière.

* Par des implantations d'ions de bore avec une relativement faible énergie sous quelques degrés d'angle de décalage par rapport à la verticale, pour éviter la canalisation d'ions.
* La profondeur de pénétration provient de l'énergie d'implantation précisément par des simulations avec les logiciels comme SRIM/TRIM ; par exemple 25 keV à travers une couche SiO₂ de 100 nanomètres d'épaisseur de passivation avec la dose : 5 - 10 × 10¹⁴ par centimètre carré.

### 9.5 Formation de la face avant, diffusion dopante de type n

^{∗} Décapage de la couche de passivation protectrice SiO₂.
^{∗} Dépôt de la source surfacique de diffusion de phosphore, par exemple, une nano couche de P₂O₅
^{∗} Diffusion à une température dite basse (< 1000°C) de phosphore à partir de la source surfacique.
^{∗} Formation de la j onction PN et de l'émetteur.

### 9.6 Opérations sur la face avant - implantation d'ions

^{∗} Décapage de la couche, source de diffusion en P₂O₅ jusqu'à 5 nanomètres d'épaisseur pour en former une nanocouche de protection.
^{∗} Implantation d'ions phosphore à travers la nanocouche protectrice de P₂O₅ avec un écart angulaire de quelques degrés par rapport à la verticale, pour éviter la canalisation d'ions.
^{∗} Profondeur d'implantation provenant de l'énergie d'implantation déterminée par simulation, en utilisant un code numérique, par exemple SRIMITRIM.
^{∗} Energie d'implantation amorphisante: 30 - 200 keV.
^{∗} Dose d'implantation est établie en dessous de 10¹⁵ ions par centimètre carré.

### 9.7 Traitement thermique

* Premier traitement thermique appliqué réduisant l'épaisseur des nanocouches amorphisées et diluant réciproquement des inclusions amorphisées dans la phase cristalline et des inclusions cristallines dans la phase amorphisée à l'intérieur de la zone de transition de phases amorphisée-cristalline.
* Cycle thermique de recuit - formation et conditionnement de sous-structures enterrées composées d'amorphisations et de systèmes à nanocouches Si cristallines transformées et structurées de manière spécifique.
   Remarque : Le traitement thermique post implantation qui suit une amorphisation dite droite est notablement simplifié et représente un bilan thermqiue amélioré particulièrement adapté à une production de masse en sérié.
   Selon ce traitement thermique les températures de recuit vont jusqu'à 700 °C ce qui s'avère particulièrement favorable à la neutralisation ou guérison de pratiquement tous les défauts structuraux étendus post implantation en vue d'un matériau plus performant.
   On procède par exemple de la même façon en ajustant la température de recuit et le cycle thermique à la qualité de l'amorphisation.

### 9.8 Décapage par ions réactifs (RIE) ou décapage chimique

^{∗} But : enlever la couche de passivation SiO₂ de protection (100 nanomètres) selon un motif pour permettre la métallisation par décapage inductif couplé au plasma (RIE).
^{∗} Décapage chimique.
^{∗} Une couche mince de 5 nanomètres est toujours conservée pour protéger la surface du semi-conducteur ; au lieu du SiO₂, il est possible d'utiliser le P₂O₅ restant après le processus de diffusion de phosphore.

### 9.9 Masque d'implantation - exemple Photolithographie

^{∗} But : enterrer des sous structures amorphisées discontinues par des implantations amorphisantes à travers un masque d'implantation avec des différents motifs et géométries selon des impératifs imposés par le transport électronique.
^{∗} Réalisation conventionnelle avec un masque photolithographique et une illumination par lampe à vapeur de mercure.
^{∗} L'opération comporte de nombreuses étapes intermédiaires avec des masques de différents motifs.
^{∗} Couverture avec de l'agent photorésistant pour protéger de façon intermédiaire les faces inférieures et supérieures.
^{∗} Exposition à la lumière : toutes les réactions mentionnées ci-dessus sont induites par la lumière.
^{∗} Processus chimiques : enlèvement des fragments selon les motifs sélectionnés.

### 9.10 Implantation ionique pour l'amorphisation à faisceau défocalisé large dite amorphisation droite

L'amorphisation classique à l'aide d'un faisceau d'ions focalisé balayant la surface de la plaquette de Si introduit inévitablement des nombreux défauts structuraux. Telle quelle, cette opération n'est pas utilisable pour la fabrication industrielle des convertisseurs à génération secondaire. Les aspects la disqualifiant peuvent être résumées ainsi : le mauvais contrôle de la modulation du matériau durant l'impact local du faisceau d'ions et, par conséquent, de son recuit post implantation ; les exigences exagérées concernant l'épaisseur de l'amorphisation initiale pour garder une marge de manoeuvre suffisante à la recristallisation guérissante; les sévères limitations concernant la conception et l'architecture du convertisseur provenant de l'emplacement de sous structures enterrées dans le réseau cristallin ; les entraves au transport électronique autour des nanostructures enterrées dans un matériau endommagé ; les complications concernant la collecte des porteurs de charges aussi bien secondaires que primaires.

Il est connu de l'homme du métier que le traitement thermique post implantation guéri quelques types des défauts structuraux. Pour des raisons imposées par les conditions de la fabrication et le conditionnement de la SEG-MATTER, ce traitement se fait dans un intervalle bien limité de températures adaptées et avec un bilan thermique raisonnable du point de vue de la fabrication.

Il existe diverses combinaisons qui conduisent à la structure de l'émetteur du convertisseurs GPC en utilisant des diffusions ou/et implantations d'impuretés dopantes.

Dans le premier cas (d'implantations de phosphore), incluant aussi bien le profil du dopant que le champ électrique de face avant (FSF) ainsi que la modification de la structure cristalline sont le résultat des implantations ioniques (de phosphore de préférence en ce qui concerne l'amorphisation).

Dans le second cas (des diffusions d'impuretés dopantes), le profil du dopant est réalisé par diffusion (phosphore de préférence), tandis que la modification de la structure cristalline est le résultat de l'implantation ionique (phosphore ou silicium de préférence).

La modification de la structure cristalline répondant aux exigences industrielles devrait être :
* Réalisée par un implanteur d'ions à spot défocalisé large, bien stabilisé et homogène, assurant une amorphisation utile industriellement (amorphisation droite).
* L'implantation de phosphore ou de silicium faite avec des énergies de 80 - 180 keV et avec une densité de 6 à 10 × 10¹⁴ ions par centimètre carré.
^{∗} Dans le cas où la diffusion de phosphore a été faite préalablement, pour obtenir l'amorphisation enterrée des ions de silicium peuvent être implantés au lieu d'ions phosphore.

### 9.11 Cycle de traitement thermique post implantation

Le traitement à faible bilan thermique sensiblement plus court que 30 min à une température d'environ 500°C dans un four à plateau, suivi d'un refroidissement progressif. Pour certains cas particuliers, un cycle thermique à séquences courtes est envisageable.

### 9.12 Métallisation des contacts arrière.

Une superposition des effets de confinement optique (miroir SiO₂/Al) et de la collecte à la face arrière par un peigne combiné avec un contact pleine surface en aluminium.

### 9.13 Métallisation des contacts avant.

Il s'agit, par exemple, de la métallisation en grille multicouche : titane/palladium/argent.

### 9.14 LPCVD ou dépôt SiO₂ par pulvérisation cathodique

**But du LPCVD** : compléter la couche SiO₂ de base d'une épaisseur de 5 nanomètres par une couche SiO₂ de protection complète d'environ 100 nanomètres (pour assurer une passivation électronique efficace). Réalisée par exemple dans un tube d'un matériau adapté, porté et stabilisé à 420°C pendant 20 minutes ; le processus de dépôt dure 5 minutes.

**But de la pulvérisation cathodique** : compléter la couche SiO₂ de protection d'environ 5 nanomètres par une couche de SiO₂ de 100 nanomètres (pour assurer une passivation électronique efficace) :
* L'opération se fait à la température ambiante
* La pression est de 2 × 10⁻³ mb
* La puissance est de 200 W
* La distance par rapport à la plaquette de silicium ciblée est de 100 nanomètres
* La durée de l'opération est de l'ordre de 13 minutes

### 10. Procédé de production en petites séries de dispositifs de photoconversion géante - traitement multi étape de plaquettes de silicium

Le nombre d'étapes de traitement dépend entre autres de l'état initial des plaquettes de silicium achetées. Les étapes principales de la fabrication concernent :
Surface : la qualité exigée de surface de la plaquette de silicium peut être obtenue par le traitement RCA, purification microélectronique, polissage à froid pour la libérer d'oxyde natif.
Epaisseur de la plaquette de silicium : doit être adaptée à toute la suite des opérations technologiques.
Oxydation sacrificielle : oxydation profonde (à 100 nanomètres) décapage de l'oxydation initiale (95 nanomètres) conservation d'une nanocouche comme nanocouche de protection (environ 5 nanomètres d'épaisseur) ou de la surface pure de silicium elle-même, prête pour un dépôt de P₂O₅ pour la nanocouche-source de la diffusion de P.
Masques de protection : surface protégée entre des opérations successives ainsi que masques d'implantation amorphisante correspondant à des motifs de sous-structures.
Face arrière : profil de type p, profil d'accepteur B par diffusion ou par implantation, BSF, passivation, miroir arrière, grille de contact.
Face avant: profil de type n, profil de donneurs P par diffusion à partir de la source sous forme de nanocouche de P₂O₅, interface de jonction PN.
Sous-structures enterrées : sous-structures actives insérées dans l'émetteur avec des excellentes caractéristiques géométriques de planéité, concept de l'architecture particulière de convertisseur.
Implantation : implantation d'ions à travers la nanocouche de protection (environ 5 nanomètres d'épaisseur).
Traitement thermique : dépôt adapté de l'énergie thermique pour moduler et conditionner le matériau transformé.
Conditionnement de SEGTON et SEG-MATTER : épitaxie en phase solide avec calibration des sous-systèmes actifs dans leur environnement.
Miroir arrière : miroir arrière de SiO₂/Al sur la face arrière pour piégeage optique.

### Recuit d'activation des contacts.

### 11. Procédé de production en petites séries de dispositifs de photoconversion géante - l'insertion des systèmes nanoscopiques dans des plaquettes de silicium - un exemple de cycle avec des séquences non exclusives mutuellement

Exemple des opérations menant à l'insertion des systèmes nanoscopiques dans un dispositif de photoconversion géante lumière-électricité, tout en silicium ; principales étapes et leurs caractéristiques :
* silicium utilisé : plaquette de silicium CZ ou FZ avec une orientation cristallographique de < 100 >,
* épaisseur de la plaquette de silicium utilisée: environ 150 - 500 micromètres,
* diamètre de la plaquette de silicium utilisée: 4, 6 ou 12 pouces,
^{∗} pré-dopage de type p : densité homogène de bore avec une densité d'environ Nₐ ~ 1 - 5.10¹⁵ cm⁻² - l'opération doit laisser la durée de vie des porteurs minoritaires maximale dans la base du convertisseur (en évitant l'activation d'impuretés involontaires et les défauts),
^{∗} oxydation sacrificielle de 50 nanomètres à une température inférieure à 100°C,
^{∗} première implantation (BSF) sur la face arrière avec du bore, à une densité de 10¹⁵ cm⁻², avec un profil de densité maximale au niveau de la surface/interface, sauf dans la zone d'alignement (utilisation du masque de la grille arrière métallique),
^{∗} décapage du SiO₂ à partir de la face avant, en utilisant du tampon HF, sauf dans la zone d'alignement,
^{∗} pré-dépôt sur la face avant d'une source de phosphore pour réaliser un dopage de type n par diffusion,
^{∗} le profil de diffusion à basse température est déterminé de façon prédictive par un logiciel de simulation, par exemple ATHENA (marque déposée),
^{∗} deuxième implantation de phosphore sur la face avant, énergie : 50 - 180 keV, dose 8.10¹⁴ cm⁻², sauf sur la zone d'alignement (par utilisation des masques d'implantation),
^{∗} cycle de traitement thermique déterminé de façon prédictive par un code de simulation,
^{∗} décapage partiel par attaque chimique du SiO₂ de la face arrière respectant le motif des doigts de contact en utilisant un masque,
^{∗} métallisation de la face arrière avec une couche de 1 micron d'aluminium,
^{∗} décapage du motif d'alignement sur la face arrière (un masque pour l'alignement),
^{∗} décapage lent de la couche de SiO₂ sur la face avant en utilisant HF: H₂O,
^{∗} tri-couche de métallisation de la grille de la face avant : Ti/Pd/Ag,
^{∗} décapage de la couche métallisée de la face supérieure dans la zone d'alignement (deux masques pour l'alignement),
^{∗} alignement infra rouge,
^{∗} décapage de la couche métallisée de la face avant (masque de la grille de la face avant).

### 12. Procédé de production en petites séries de dispositifs de photoconversion géante - exemple A : implantation, amorphisation et dopage de type n à l'aide d'ions phosphore - un exemple de cycle avec des séquences non exclusives mutuellement

### A. Implantation seulement

Un exemple de solution du procédé fondé uniquement sur l'implantations d'ions, caractérisé par les étapes suivantes :
1) Nettoyage RCA.
2) Oxydation thermique 1000 Å.
3) Implantation n°1 : bore à travers la face arrière et l'oxyde thermique 1000 Å.
4) Dépôt de résine sur la face arrière.
5) Photolithographie de la face arrière et figure de calibration (masque 1).
6) Amincissement de la face avant, jusqu'à 50 Å.
7) Enlèvement de la protection résine sur la face arrière.
8) Masque d'implantation apposé sur une couche de polysilicium ayant une épaisseur de 0,2 micromètres.
9) Photolithographie de différents doigts avec différents espaces sur du polysilicium (100, 200 micromètres ayant une largeur identique pour tous de 500 micromètres (masque 6).
10) Implantation n°2 : implantation de phosphore amorphisant dans le canal 0. 180 keV 7.10¹⁴ At/cm².
11) Enlèvement total du polysilicium.
12) Implantation n°3 avec un profil de sur-dopage, le phosphore est utilisé pour le canal de la face avant, avec les caractéristiques suivantes : 0,25 keV, 7.10¹⁴ At/cm².
13) Traitement thermique post implantation.
14) Traitement de deux ensembles de plaquettes de silicium dans un mode de diffusion parallèle « parfait ».
15) Protection intermédiaire de la face avant.
16) Décapage photolithographique du doigt de la grille sur la face arrière.
17) Décapage photolithographique du doigt d'attaque 1000 Å de SiO₂.
18) Enlèvement de la résine de protection de la face avant.
19) Traitement total de la face arrière de la plaquette de silicium avec un dépôt d'aluminium de 2 micromètres.
20) Protection par résine de la face arrière.
21) Photolithographie du peigne de la face avant (masque 3).
22) Lithographie du peigne en décapage 50 Å de SiO₂.
23) Enlèvement de la protection résine de la face arrière.
24) Décapage des contacts (masque 4) pour l'enlèvement.
25) Dépôt d'une couche double Ti/Au - 150 microns/1 micron.
26) Enlèvement par soulèvement (lift-off).
27) Dépôt de SiO₂ par CVD ou pulvérisation cathodique sur la face avant.
28) Protection de la face arrière par de la résine.
29) Décapage photolithographique de contact de la face avant (masque 5).
30) Décapage photolithographique sous oxyde du contact de la face avant.
31) Enlèvement de la résine de protection sur la face arrière.
32) Recuit des contacts sous atmosphère N₂H₂ pour une caractérisation en cours de traitement.
33) Protection par de la résine sur la face avant pour la découpe.
34) Découpe de la cellule sur la plaquette de silicium en la collant sur du ruban adhésif bleu.

### 13. Procédé de production en petites séries de dispositifs de photoconversion géante - exemple B : dopage de type n à l'aide de la diffusion phosphore, implantation amorphisante à l'aide d'ions phosphore - un exemple de cycle avec des séquences non exclusives mutuellement

### B. Diffusion et implantation

Un exemple de solution du procédé fondé sur la diffusion et implantation d'ions, caractérisé par les étapes suivantes :
1) Nettoyage RCA.
2) Oxydation thermique 1000 Å.
3) Implantation n°1 : bore sur la face arrière à travers la couche d'oxyde thermique de 1000 Å.
4) Protection de la face arrière par de la résine.
5) Décapage lithographique de la zone active et de la figure de calibration de la face avant (masque 1).
6) Enlèvement total du SiO₂.
7) Enlèvement de la résine de protection sur la face avant.
8) Dépôt de l'oxyde P₂O₅ par source de diffusion et utilisation d'une couche de passivation.
9) Diffusion P.
10) Amincissement de l'oxyde P sur la face avant.
11) Recuit du P diffusé.
12) Masque d'implantation dépôt d'une couche de polysilicium ayant une épaisseur de 0,2 micromètres.
13) Décapage photolithographique du polysilicium : plusieurs espacements des doigts 100, 200, 500 micromètres. Ils ont tous la même largeur de 500 nanomètres (masque 6).
14) Implantation amorphisante avec du phosphore sur la face avant dans un canal à 0 degrés d'angle avec 180 keV et 7.10¹⁴ At/cm².
15) Enlèvement total du polysilicium.
16) Recuit après l'implantation.

### 14. Procédé de production en petites séries de dispositifs de photoconversion géante - exemple d'oxydation thermique

L'oxydation thermique de la cellule GPC peut se faire dans un four d'oxydation, exploité en microélectronique, atteignant 1000°C sous N₂, O₂, H₂, HCl et formant une couche d'oxyde de 0,5 à 1,6 µm d'épaisseur.

### 15. Procédé de production en petites séries de dispositifs de photoconversion géante - exemple de courant du faisceau d'ions

Les caractéristiques d'implantation avec le spot focalisé nécessitent un courant de faisceau de 3 microampères à 2 milliampères, le voltage d'accélération s'étendant de 5 à 200 kV, jusqu'à 125 de masse atomique, avec la capacité de traiter des échantillons de plaquettes de silicium allant de 1 cm² à 6 pouces de diamètre.

### 16. Procédé de production en petites séries de dispositifs de photoconversion géante - exemple de la création d'un champ de la face avant

La création d'un champ électrostatique intrinsèque sur la face avant de la plaquette de silicium pour fabriquer une cellule GPC peut se faire à l'aide d'implantation peu profonde d'ions phosphore (profondeur < 1.0 µm). Cette deuxième implantation de la cellule GPC peut se faire avec le même implanteur d'ions travaillant dans l'intervalle d'énergies plus faibles formant le profil peu profond d'impuretés.

### 17. Procédé de production en petites séries de dispositifs de photoconversion géante - exemple d'un traitement thermique fondé sur des effets thermodynamiques de cristallisation

Le premier recuit de la cellule GPC à environ 500°C devrait être, en général, suivi par la seconde opération de recuit en cycle avec des étapes de chauffage et de refroidissement. Le cycle peut être réalisé dans le même four que celui utilisé pour l'étape de premier recuit.

### 18. Procédé de production en petites séries de dispositifs de photoconversion géante - exemple des valeurs pour démarrer le processus par ajustement itératif de la machine de fabrication des cellules GPC par un processus spécifique de caractérisation

**Tableau des valeurs pour démarrer.**

| **Machine de fabrication sélectionnée** | **Fonctions mises en oeuvre** | **Valeurs des paramètres** |
|---|---|---|
| Four à haute température | Oxydation thermique | ^{∗}Diffusion d'ions oxygène à une température <1000°C (tolérance 3%) |
| | | ^{∗}Epaisseur d'oxyde 600 Å |
| Implanteur d'ions pour l'implantation à faisceau défocalisé large | Implantation d'ions de bore (face arriéré) | ^{∗}Dose 5×10¹⁴ par centimètre carré (tolérance 3%) |
| | | ^{∗}Energie 25 keV (tolérance 1%) |
| | | ^{∗}Décalage axial de quelques degrés (tolérance 0,5 degré) |
| Implanteur d'ions pour l'implantation à faisceau défocalisé large | Implantation d'ions phosphore (face avant) | ^{∗}Dose < 10¹⁵ ions par centimètre carré (tolérance 3%) |
| | | ^{∗}Puissance 20 keV (tolérance 1%) |
| | | ^{∗}Passivation du substrat SiO₂, P₂O₅ épaisseur 5 nanomètres |
| | | ^{∗}Décalage axial de quelques degrés pour éviter la canalisation d'ions pour une meilleure précision (tolérance 1 degré) |
| Four à oxydation | *Champ de surface avant | ^{∗}Température 850°C (tolérance 3%) |
| | *Formation de profil P par diffusion | |
| | | ^{∗}Durée 2 heures (tolérance 1%) |
| Microphotolithographie | Recouvre certaines parties de l'échantillon pour les protéger de l'implantation, en créant ev. différentes géométries et formes de couches amorphisées | Couverture avec un agent photorésistant pour protéger les zones non traitées contre le processus en cours, par ex., des effets du micro décapage chimique par voie humide. |
| Implanteur d'ions pour l'amorphisation à faisceau défocalisé large | Implantation d'ions phosphore, bore ou silicium | ^{∗}Puissance 180 keV (tolérance 10%) |
| | | ^{∗}Densité d'ions phosphore 10⁴ par centimètre carré (tolérance 10%) |
| Recuit avec un four à cycles | Recuit | ^{∗}Durée 30 minutes (tolérance 10%) |
| | | ^{∗}Température ≤ 500°C (tolérance 10%) |
| | | ^{∗}Exposition à la chaleur rapide avec un refroidissement en 1/10 seconde (tolérance 5%) |
| Machine de décapage à ions réactifs | Zones traitées RIE sélectionnées pour être enlevées | ^{∗}Une couche mince de 5 nanomètres de SiO₂ est conservée |
| | | ^{∗}80 nanomètres enlevés (tolérance 1%) HF solution avec un traitement de 80 nanomètres par minutes (tolérance 1%) |
| | | 15 nanomètres sont enlevés par un mélange d'eau et de tampon (1 millilitre) |
| Four pour LPCVD | Dépôt d'une couche de protection de 100 nm | Epaisseur 10 nm (tolérance 3%) |
| Machine de pulvérisation cathodique | Dépôt de 100 nanomètres de SiO₂ opérant comme couche de protection | ^{∗}Température ambiante, pression 2.10⁻³ torr (tolérance 3%) |
| | | ^{∗}Puissance 200W (tolérance 10%), distance à la cible 100 nanomètres (tolérance 3%) |
| | | ^{∗}Durée 10 minutes (tolérance 3%) |

Les valeurs initiales concernant l'équipement sélectionné pour la fabrication, ont été obtenues avec le logiciel CAD CAM qui fournit des données de réglage au début du processus itératif pour la machine de micro fabrication avec une marge d'erreur réduite par des spécificités de la fabrication du métamatériau et des machines adéquates.

### 19. Procédé de production en petites séries de dispositifs de photoconversion géante - exemples des transformations nanoscopiques du silicium cristallin en un arrangement optimal pour former des sous-systèmes actives enterrés

Le procédé de fabrication selon cette invention, constitue une transformation nanoscopique du silicium cristallin en un arrangement optimal pour former des sous-systèmes enterrés dans le réseau cristallin permettant d'améliorer le rendement de la conversion lumière-électricité. Tous les paramètres, procédures et étapes de fabrication de la GPC ont été testés et validés séparément et en association, durant la fabrication de nombreuses séries test.

Pour être utile en matière de conversion lumière-électricité, le silicium doit subir une transformation complexe qui conduira les défauts structurels distribués normalement de façon rare, aléatoire et dispersée à une structure composée d'unités élémentaires dénommées SEGTONS du super réseau ordonné en formant un métamatériau appelé SEG-MATTER. Les aspects les plus importants concernent la nature, la densité et le nombre des défauts ponctuels convenablement positionnés à l'intérieur de l'espace du convertisseur.

Pour assumer ses fonctions, la nanocouche de métamatériau est intégrée dans un matériau (de préférence en silicium cristallin, c-Si), correctement dopé de type n. Cette couche est bornée par deux interfaces planes (nanomembranes) la délimitant selon une invention antérieure.

L'épaisseur de la nanocouche en métamatériau (nanocouche <c-Si>) et la densité des SEGTONs, greffés sont autocontrôlées durant la fabrication, par la contrainte mécanique locale, (provenant de dilatations entre a-Si et c-Si), induites par, et résultant de, la recristallisation en cycles (épitaxie en phase solide) intervenant à des températures adaptées. Des expérimentations (rayons X, LEED) montrent que du côté de la phase cristalline (bien visualisée par des techniques disponibles) l'épaisseur finale de la nanocouche SEG-MATTER est de l'ordre de 5 à 10 nanomètres.

En gardant à l'esprit toutes les étapes individuelles, on les intègre dans un seul et complet procédé de fabrication du type industriel. Comme résultat, les données principales relatives au à la SEG-MATTER concernent :
- une profonde transformation locale des semi-conducteurs (préférablement c-Si), possible à échelle nanométrique, qui conduit à un métamatériau cristallin dénommé SEG-MATTER,
- une densité importante (10²⁰ cm⁻³) des SEGTONs dans le métamatériau avec une répartition homogène,
- composition uniforme et stabilisée des nanocouches de SEG-MATTER,
- quantité suffisante de l'ensemble des nanocouches de métamatériaux correspondant à l'intensité du flux incident de photons,
- position spatiale adaptée du système SEG-MATTER qui doit être proche de l'endroit où il y a l'absorption des photons énergétiques (optimisation spatiale) :
   * proximité et/ou unité de la zone d'absorption et des zones de génération secondaire ;
   * surface maximale et optimisée d'exposition (formes et arrangements) pour des interactions de collisions avec des électrons chauds.

La nanocouche de métamatériau est prévue pour résister et persister à des traitements se faisant à des températures inhabituellement relativement élevées (450 - 550°C et 250 - 450°C) pour les bilacunes à cause du maintien des contraintes mécaniques locales. Cette caractéristique se différencie du fait bien connu de l'homme du métier que les bilacunes se recombinent à des températures inférieures à 250°C.

Les problèmes les plus spécifiques concernent la concaténation des opérations se suivant consécutivement, car certaines s'excluent mutuellement. Par exemple, dans la présente invention les températures des processus successifs dans le cycle de fabrication, s'étagent impérativement des plus élevées vers les plus basses, en respectant chacune les étapes décrites précédemment.

Des convertisseurs lumière-électricité contenant les sous-structures (continues ou discontinues) dans l'émetteur ont été décrites auparavant. Un des plus importants éléments constituant la sous-région, sous-système et sous-structure dédiés, est un composant artificiel à nanoéchelle qui devrait être capable de compléter la conversion classique par une amélioration due aux mécanismes nouveaux.

Ceci est assuré par un matériau artificiel (SEG-MATTER), formé entre autre, à partir d'unités de construction bien définis, ayant une densité bien déterminée et localisée d'une façon bien définie dans le volume bien déterminé du convertisseur. Pour assurer la complète fonctionnalité de la conversion des SEGTONs et de la SEG-MATTER on doit remplir un nombre de conditions strictes.

En général, la solution nécessite des séquences spécifiques d'opérations connues, qui doivent être paramétrées d'après les données physiques et technologiques du processus.

La fabrication d'un dispositif GPC nécessite l'intégration d'une série d'opérations qui sont, d'une part bien connues dans la technologie photovoltaïque et microélectronique (opérations, procédures, machines) et d'autre part, ne peuvent pas être appliquées telles quelles, à cause de leurs de conditions spécifiques liées aux grandes surfaces actives des dispositifs.

La fabrication peut être entreprise sur des équipements existants à l'aide de quelques adaptations mineures. Pratiquement toutes les machines nécessaires et les outils ont été testés et sont normalement disponibles dans l'industrie. La future fabrication à grande échelle sera opérationnelle sur des machines de production dédiées, plus simples et notablement moins onéreuses.

Par exemple, la structure d'un dispositif test contient une passivation électronique SiO₂ réalisée par une méthode de dépôt par vapeur sous faible pression. La couche de passivation a une épaisseur de 100 nanomètres. Le silicium cristallin dopé au phosphore, présente une épaisseur égale ou plus faible de 170 nanomètres, l'épaisseur de la couche, fortement dopée de silicium amorphisé, a une épaisseur de 20 nanomètres, la jonction PN est à 1 micron sous la surface (cette donnée est peu contraignante). La couche amorphisée est gonflée en provoquant une contrainte mécanique provenant du désaccord du réseau cristallin et de l'amorphisation.

Le contact de face arrière peut-être réalisé en aluminium et les électrodes de face avant peuvent être en argent ou en tri couche métallique.

L'originalité principale de la technologie de fabrication inventée réside dans l'éventail des opérations spécifiques par rapport à la technologie habituelle des cellules cristalline Si et dans l'organisation des étapes de fabrication. Les contraintes principales viennent du fait que les sous structures GPC ne peuvent pas être chauffées au-delà de 500°C.

Une fois la couche de méta matériau fabriquée, pour créer la couche de passivation sans chauffer trop fortement, il faut utiliser le dépôt chimique en phase vapeur, qui peut être réalisé à basse température (ce qui n'est pas le cas de l'oxydation thermique). Ainsi, la meilleure façon de procéder est d'utiliser un compromis :
- procéder d'abord à une première oxydation thermique,
- l'amincir ensuite la couche de SiO₂ par un décapage jusqu'à 5 nanomètres,
- créer la couche nanostructurée par implantation d'ions à faisceau défocalisé large,
- ajuster le système de nanocouches par un recuit à cycles,
- revenir à la passivation électronique pour augmenter son épaisseur par dépôt chimique.

### Exemple :

* matériau : silicium CZ ou FZ sous la forme de plaquettes avec une orientation cristallographique de < 100 >,
* pré dopage de type p au bore de 1 à 5.10¹⁵ At par centimètre cube de densité homogène,
* la durée de vie des porteurs minoritaires doit être aussi longue que possible (elle dépend de la qualité, structurelle du matériau),
* diamètre et épaisseur de la plaquette de silicium : 4, 6 ou 12 pouces, 150 - 500 micromètres d'épaisseur,
* épaisseur de la couche d'oxydation sacrificielle initiale accrue à une température inférieure à 1000°C,
* première implantation à la face arrière avec du bore : 10¹⁵ At/cm², menant à un profil ayant son maximum à la surface sauf sur la zone d'alignement,
* décapage du SiO₂ à partir de la face avant avec du tampon HF, sauf sur la zone d'alignement,
* pré dépôt d'une source de diffusion de phosphore sur la face avant,
* diffusion avec un profil déterminé par la simulation préalable établie avec le logiciel, par exemple ATHENA,
* deuxième implantation sur la face avant du phosphore, énergie 180 keV dose 8×10¹⁴ At/cm², sauf sur la zone d'alignement ; amorphisation « droite ».

### Cycle de traitement thermique

* décapage partiel du SiO₂ de la face arrière, en respectant les motifs des doigts de contact,
* métallisation de la face arrière ; dépôt d'une couche Al de 1 µm,
* décapage de la face arrière selon les motifs d'alignement (masque éventuel),
* décapage lent du SiO₂ de la face avant avec HF: H₂O,
* métallisation tri couche de la face avant : Ti/Pd/Ag,
* décapage du métal de la face selon le motif de la zone de contact.

### 20. Machines pouvant servir de références pour mettre en oeuvre le procédé de production selon la présente invention

La liste ci-après est un exemple non exhaustif.
- Machine pour le décapage ionique réactif de la plaquette de silicium : des machines de décapage par plasma à couplage inductif par exemple la machine AVI21 TEC OMEGA 201 ayant une puissance inductive RF de 600W (13,56 MHz) une puissance de serrage RF de 600W (13,56 MHZ), une température de traitement de 10 à 20 degrés Celsius et la possibilité d'utiliser les gaz suivants : SF₆, CF₄, O₂, CHF3, AR avec le refroidissement de la face arrière du GPC par hélium ;
- Equipement standard de photolithographie de production (masque courant d'ateliers en tant qu'instruments) nécessaire uniquement dans le cas d'un GPC avec sous-structures discontinues. Le masque d'alignement constitue un exemple des instruments nécessaires ;
- Implanteur d'ions pour le second traitement de la cellule GPC;
- Deuxième étape de recuit pour la cellule GPC : four identique à celui utilisé pour la première étape de recuit à variation rapide de température pilotable par ordinateur ;
- Machine de pulvérisation cathodique pour la métallisation des contacts arrière de la cellule GPC, comme par exemple la UNIVEX 450C, le métal pouvant être de l'aluminium, la puissance RF ou DC et la limite de vide nécessaire étant de 1.10⁻⁷ torr ;
- Machine VARIAN 3 6 16 pour la métallisation des contacts avant avec du titane, du palladium ou de l'argent de la cellule GPC en utilisant un canon à électrons pour l'évaporation, de puissance 6 kW avec une pompe cryogénique, et un minimum de pression est 5.10⁻⁷ bar ;
- Instrument pour la création d'une couche de protection de 100 nanomètres en SiO₂ pour la passivation de la cellule GPC par un four LPCVD tel que le LPCVD6 dont les caractéristiques sont : température maximale 580 °C, longueur de la zone plateau 50 cm, gaz : N₂, NH₃, SiH₄, SiH₂Cl₂, N₂O ;
- Machine de pulvérisation cathodique de SiO₂ ou ITO sur la cellule GPC telle que l'ALCATEL 600 avec une pompe cryogénique et une source électrique RF ou DC et une pression de 10⁻⁷ torr ;
- Machine pour le nettoyage final de la cellule GPC pour circuits de microélectronique ayant un contrôle atmosphérique de classe 100, des sécheurs à azote utilisant de l'eau débarrassée d'ions, une fonction de mesure de résistivité pour mesurer la qualité du séchage et du nettoyage entre les différents bains, les vapeurs étant extraites par le fond en haut du dispositif.

## Revendications

1. Procédé de production de convertisseurs lumière-électricité tout en silicium présentant des sous-systèmes nanoscopiques conditionnés en arrangements spécifiques à l'intérieur du silicium cristallin, basé sur une implantation amorphisante qui amorphise localement le réseau cristallin de silicium dans une zone prédéterminée en épaisseur et en profondeur, suivie d'un traitement thermique post implantation entraînant une recrystallisation locale contrôlée sous forme d'épitaxie en phase solide, le procédé étant **caractérisé par** les étapes suivantes réalisées dans cet ordre :
A. Mise à disposition d'une plaquette de silicium monocristallin d'orientation <100> de Type-p pré-dopé avec du bore en concentration usuelle 10¹⁵ par centimètre cube, et nettoyage des faces avant et arrière
B. Nettoyage dans un bain RCA dans une station de nettoyage chimique et oxydation thermique sacrificielle à une température de 850°C pendant 2 heures, pour aboutir à une couche sacrificielle de SiO₂ de 50 à 100 nanomètres
C. Oxydation thermique dans un four, avec diffusion d'ions oxygène
D. Formation de champ de surface (BSF) sur la face arrière de la plaquette avec une implantation par bore ionique de relativement faible énergie, avec un angle par rapport à la verticale, de quelques degrés, pour éviter la canalisation d'ions
E. Formation de la face avant par le décapage de la couche protectrice SiOz de passivation et la déposition d'une nano-couche de P₂O₅ comme source de diffusion de surface pour établir un profil P et réaliser une diffusion à une température basse inférieure à 1000°C de phosphore à partir de la source de surface, afin de former une une jonction PN et un émetteur
F. Opérations sur la face avant comprenant les étapes de décapage de la couche source de diffusion de P₂0₅ jusqu'à 5 nanomètres d'épaisseur pour en former une nanocouche de protection, et par l'implantation d'ions phosphore à travers la nanocouche de protection en P₂0₅ , avec un décalage de quelques degrés par rapport à la verticale pour éviter la canalisation d'ions, avec une profondeur d'implantation provenant d'une énergie d'implantation déterminée par simulation, avec une énergie d'implantation amorphisante entre 30 et 200 keV et une dose d'implantation située en dessous de 10¹⁵ ions par centimètre carré, afin de réaliser des nanocouches amorphisées
G. Exécution d'un traitement thermique pour réduire l'épaisseur des nanocouches amorphisées et diluer des inclusions amorphisées dans la phase crystalline et des inclusions cristallines dans la phase amorphisée à l'intérieur de la zone de transition de phases amorphisée-cristalline,
et d'un cycle de recuit pour la formation de sous-structures enterrées composées d'amorphisations et de systèmes à nanocouches Si cristallines transformées et structurées de manière spécifique,
H. Décapage par ions réactifs RIE ou par décapage chimique afin d'enlever la couche de sacrificielle de SiO₂ selon un motif pour permettre la métallisation, dans lequel une couche mince de 5 nanomètres est conservée pour protéger la surface,
I. Formation d'un masque d'implantation pour enterrer des sous structures amorphisées discontinues par des implantations amorphisantes à travers le masque d'implantation, le masque d'implantation ayant différents motifs et géométries selon des impératifs imposés par le transport électronique,
J. Implantation ionique pour l'amorphisation de la structure cristalline réalisée par un implanteur d'ions à faisceau défocalisé large, stabilisé et homogène, pour réaliser l'implantation de phosphore à 180 keV à une densité 6-10 × 10¹⁴ ions par centimètre carré,
K. Cycle de traitement thermique post implantation sensiblement plus court que 30 minutes dans un four à 500°C suivi par un refroidissement progressif
L. Réalisation d'une métallisation de la face arrière qui combine des effets de confinement optique au moyen d'un miroir SiO2/Al et de collecte en face arrière par un peigne combiné avec un contact pleine surface en aluminium,
M. Réalisation d'une métallisation de la face avant en grille multicouche titane/palladium/argent
N. LPCVD ou dépôt SiO2 par pulvérisation cathodique pour compléter la couche de SiO2 de base d'une épaisseur de 5nm et créer une couche de 100 nm de SiO₂ de passivation électronique.

## Patentansprüche

1. Verfahren zur Herstellung von Licht/Strom-Wandlern ganz aus Silizium, die nanoskopische Teilsysteme aufweisen, die in spezifischen Anordnungen im Innern des kristallinen Siliziums aufbereitet sind, basierend auf einer amorphisierenden Implantation, die das Siliziumkristallgitter in einem vorbestimmten Bereich in der Dicke und in der Tiefe lokal amorphisiert, gefolgt von einer Wärmebehandlung nach der Implantation, die eine kontrollierte lokale Rekristallisierung in Form einer Festphasenepitaxie herbeiführt, wobei das Verfahren durch folgende Schritte gekennzeichnet ist, die in dieser Reihenfolge durchgeführt werden:
A. Bereitstellung eines monokristallinen Silizium-Wafers mit einer <100>-Ausrichtung vom Typ P, vordotiert mit Bor in einer üblichen Konzentration von 10¹⁵ pro Kubikzentimeter, und Reinigung der Vorder- und Rückseite,
B. Reinigung in einem RCA-Bad in einer Station zur chemischen Reinigung und thermischen Opferoxidation bei einer Temperatur von 850 °C für 2 Stunden, um eine Opferschicht aus SiO₂ von 50 bis 100 Nanometern zu erreichen,
C. Thermische Oxidation in einem Ofen mit Sauerstoffionendiffusion,
D. Bildung eines Oberflächenfeldes (BSF) auf der Rückseite des Wafers mit einer Implantation von Bor-Ionen relativ geringer Energie in einem Winkel im Verhältnis zur Senkrechten von einigen Grad, um die Ionenkanalisierung zu vermeiden,
E. Bildung der Vorderseite durch Ätzen der passivierenden SiO₂-Schutzschicht und Abscheidung einer P₂O₅-Nanoschicht als Oberflächendiffusionsquelle, um ein P-Profil herzustellen und eine Diffusion bei einer niedrigen Temperatur von weniger als 1000 °C von Phosphor aus der Oberflächenquelle durchzuführen, um einen PN-Übergang und einen Emitter zu bilden,
F. Operationen an der Vorderseite, welche die Schritte des Ätzens der P₂O₅-Diffusionsquellenschicht bis auf eine Dicke von 5 Nanometern umfassen, um eine Schutznanoschicht zu bilden, und durch die Implantation von Phosphorionen durch die P₂O₅-Schutznanoschicht hindurch mit einem Versatz einer Grade im Verhältnis zur Senkrechten, um die Ionenkanalisierung zu vermeiden, wobei eine Implantationstiefe aus einer Implantationsenergie stammt, die durch Simulation bestimmt wird, mit einer amorphisierenden Implantationsenergie zwischen 30 und 200 keV und einer Implantationsdosis, die unterhalb von 10¹⁵ Ionen pro Quadratzentimeter liegt, um amorphisierte Nanoschichten auszubilden,
G. Durchführung einer Wärmebehandlung, um die Dicke der amorphisierten Nanoschichten zu reduzieren und amorphisierte Einschlüsse in der kristallinen Phase und kristalline Einschlüsse in der amorphisierten Phase im Innern des Übergangsbereichs der amorphisierten/kristallinen Phasen zu verdünnen,
und eines Ausglühzyklus zur Bildung von vergrabenen Unterstrukturen, die aus Amorphisierungen und Systemen mit spezifisch transformierten und strukturierten kristallinen Si-Nanoschichten bestehen,
H. reaktives Ionenätzen, RIE, oder chemisches Ätzen, um die SiO₂-Opferschicht in einem Muster abzutragen, um die Metallisierung zu ermöglichen, wobei eine dünne Schicht von 5 Nanometern erhalten bleibt, um die Oberfläche zu schützen,
I. Bildung einer Implantationsmaske zum Vergraben der intermittierenden, amorphisierten Unterstrukturen durch amorphisierende Implantationen durch die Implantationsmaske hindurch, wobei die Implantationsmaske verschiedene Muster und Geometrien gemäß den Anforderungen aufweist, die durch den elektronischen Transport vorgeschrieben sind,
J. Implantation von Ionen für die Amorphisierung der Kristallstruktur, die durch eine Ionenimplantiervorrichtung mit breitem stabilisierten und einheitlichen defokussierten Strahl durchgeführt wird, um die Implantation von Phosphor bei 180 keV mit einer Dichte von 6-10 × 10¹⁴ Ionen pro Quadratzentimeter durchzuführen,
K. Wärmebehandlungszyklus nach der Implantation, der im Wesentlichen kürzer als 30 Minuten ist, in einem Ofen bei 500 °C, gefolgt von einer schrittweisen Abkühlung,
L. Durchführung einer Metallisierung der Rückseite, welche die Effekte einer optischen Einschließung mittels eines SiO₂/Al-Spiegels und einer rückseitigen Sammlung durch einen kombinierten Kamm mit vollflächigem Kontakt aus Aluminium kombiniert,
M. Durchführung einer Metallisierung der Vorderseite als Titan/Palladium/Silber-Mehrfachschicht-Gitter,
N. LPCVD oder SiO₂-Abscheidung durch Kathodenzerstäubung, um die SiO₂-Grundschicht mit einer Dicke von 5 nm zu vervollständigen und eine Schicht von 100 nm SiO₂ zur elektronischen Passivierung zu erstellen.

## Claims

1. A method for the production of light-to-electricity converters made entirely from silicon having nanoscopic subsystems packaged in specific arrangements within the crystalline silicon, based on an amorphization implantation that locally amorphizes the silicon crystal lattice in a predetermined area in thickness and depth, followed by a post-implantation heat treatment, resulting in controlled local recrystallization in the form of solid-phase epitaxy, the method being **characterized by** the following steps, carried out in this order:
A. Provision of a p-type monocrystalline silicon wafer having an orientation of <100> and pre-doped with boron in the usual concentration of 10¹⁵ per cubic centimeter, and cleaning of the front sides and backsides
B. Cleaning in an RCA bath at a chemical cleaning station and sacrificial thermal oxidation at a temperature of 850 °C for 2 hours, resulting in a 50-100 nanometer SiO₂ sacrificial layer
C. Thermal oxidation in a furnace, with oxygen ion diffusion
D. Formation of a surface field (BSF) on the backside of the wafer with relatively low-energy ionic boron implantation at an angle of a few degrees to vertical in order to prevent ion channeling
E. Formation of the front side by stripping the protective SiO₂ passivation layer and depositing a P₂O₅ nanolayer as a surface diffusion source in order to establish a P-profile, and performing low-temperature diffusion below 1000 °C of phosphorus from the surface source to form a p-n junction and an emitter
F. Performing operations on the front side, including the steps of etching the P₂O₅ diffusion source layer to a thickness of 5 nanometers in order to form a protective nanolayer therefrom and implanting phosphorus ions through the P₂O₅ protective nanolayer with an offset of a few degrees from vertical to prevent ion channeling, with an implantation depth resulting from an implantation energy determined by simulation, and with an amorphization implantation energy of between 30 and 200 keV and an implantation dose of below 10¹⁵ ions per square centimeter in order to achieve amorphized nanolayers
G. Execution of heat treatment in order to reduce the thickness of amorphized nanolayers and dilute amorphized inclusions in the crystalline phase and crystalline inclusions in the amorphous phase within the amorphous-crystalline phase transition region, and of an annealing cycle in order to form buried substructures composed of amorphizations and specifically transformed and structured crystalline Si nanolayer systems,
H. Performing reactive ion etching RIE or chemical etching in order to remove the SiO₂ sacrificial layer in a pattern so as to enable metallization, in which a 5-nanometer thin layer is retained to protect the surface,
I. Formation of an implantation mask to bury discontinuous amorphous substructures by means of amorphous implantations through the implantation mask, the implantation mask having different patterns and geometries according to requirements imposed by the electronic transport,
J. Ion implantation for the amorphization of the crystalline structure performed by means of a wide, stabilized, and homogeneous defocused-beam ion implanter in order to achieve phosphorus implantation at 180 keV at a density of 6-10 × 10¹⁴ ions per square centimeter,
K. Performing a post-implantation heat treatment cycle for substantially shorter than 30 minutes in a 500 °C furnace, followed by gradual cooling
L. Performing backside metallization which combines optical confinement effects by means of a SiO₂/Al mirror and backside collection using a comb combined with a full-surface aluminum contact,
M. Metallization of the front side with a titanium/palladium/silver multilayer grid
N. Performing LPCVD or SiO₂ sputter deposition to complete the 5 nm SiO₂ base layer and create a 100 nm SiO₂ electronic passivation layer.
